# EUROPÄISCHE PATENTSCHRIFT

(11) **EP 3 426 816 B1**
(45) Veröffentlichungstag und Bekanntmachung des Hinweises auf die Patenterteilung: **29.07.2026**
(21) Anmeldenummer: 17718326.6
(22) Anmeldetag: 03.03.2017
(51) Int. Cl.: C23C 14/06, C23C 28/04, C23C 28/00, B22F 3/105, B22F 3/15, C22C 1/04, C23C 14/34

(54) **VERFAHREN ZUR HERSTELLUNG EINER HARTSTOFFSCHICHT AUF EINEM SUBSTRAT UND ZERSPANWERKZEUG MIT EINEM SUBSTRAT AUS HARTMETALL**
METHOD FOR PRODUCING A HARD MATERIAL LAYER ON A SUBSTRATE AND MACHINING TOOL WITH A SUBSTRATE OF HARD MATERIAL
PROCÉDÉ DE FABRICATION D'UNE COUCHE DE MATÉRIAU DUR SUR UN SUBSTRAT ET OUTIL D'USINAGE COMPORTANT UN SUBSTRAT EN MATÉRIAU DUR

(30) Priorität: 07.03.2016 AT 4916 U
(43) Veröffentlichungstag der Anmeldung: 16.01.2019
(60) Teilanmeldung: 21189586.7
(73) Patentinhaber: Ceratizit Austria Gesellschaft m.b.H., 6600 Reutte (AT); PLANSEE COMPOSITE MATERIALS GMBH, 86983 Lechbruck am See (DE)
(72) Erfinder: CZETTL, Christoph, A-6600 Reutte (AT); POHLER, Markus, A-6600 Reutte (AT); POLCIK, Peter, D-86983 Lechbruck am See (AT); KATHREIN, Martin, Puebla, CP75760 (MX)
(74) Vertreter: Ciesla, Dirk
(86) Internationale Anmeldenummer: PCT/AT2017/000010
(87) Internationale Veröffentlichungsnummer: WO 2017/152196

(56) Entgegenhaltungen:
- WO-A1-2015/034203
- DE-T5- 112014 004 132
- US-A1- 2001 002 855
- US-A1- 2009 186 230
- US-A1- 2014 272 391
- YUNG-I CHEN ET AL: "Preparation and annealing study of CrTaN coatings on WC-Co", SURFACE AND COATINGS TECHNOLOGY, vol. 206, no. 7, 2011, pages 1640 - 1647, XP028126183, ISSN: 0257-8972, [retrieved on 20110617], DOI: 10.1016/J.SURFCOAT.2011.06.012
- M CEKADA ET AL: "Characterization of (Cr,Ta)N hard coatings reactively sputtered at low temperature", VACUUM, vol. 52, 1 January 1999 (1999-01-01), pages 461 - 467, XP055382061

## Beschreibung

### Technisches Gebiet

Die vorliegende Erfindung betrifft ein Verfahren zur Herstellung einer Hartstoffschicht auf einem Substrat nach Anspruch 1, wobei auf dem Substrat mittels PVD ein Mehrlagenschichtensystem abgeschieden wird. Das Verfahren dient bevorzugt zur Herstellung von Zerspanwerkzeugen zum Drehen, Fräsen oder anderen spanenden Bearbeitungsverfahren.

Weiterhin betrifft die vorliegende Erfindung eine Hartstoffschicht sowie ein Zerspanwerkzeug, bevorzugt einen Schneidkörper oder eine Wendeschneideplatte oder ein Vollhartmetallwerkzeug.

Die vorliegende Offenbarung betrifft weiterhin ein Verfahren zur Herstellung einer Beschichtungsquelle sowie eine Beschichtungsquelle zur Durchführung des Verfahrens zur Herstellung einer Hartstoffschicht auf einem Substrat, die nach den Ansprüchen nicht zur beanspruchten Erfindung gehören.

### Stand der Technik

Es ist bekannt, zur Erhöhung der Verschleißbeständigkeit von auf Verschleiß beanspruchten Spanwerkzeugen und anderen Bauteilen Hartstoffschichten aufzubringen, welche die Verschleißbeständigkeit der jeweiligen Bauteile weiter erhöhen.

Die jeweilige Hartstoffbeschichtung wird dabei üblicherweise mittels physikalischer oder chemischer Schichtabscheidung aus der Gasphase auf ebenfalls verschleißbeständige Substratwerkstoffe abgeschieden. Als Substratwerkstoffe werden hier beispielsweise Hartmetalle, Cermets, Hartstoffe oder Werkzeugstähle verwendet.

Unter Hartmetall wird ein Verbundwerkstoff verstanden, welcher üblicherweise eine Hauptphase aus Wolframcarbid (WC) sowie gegebenenfalls Phasen von weiteren Carbiden und einen metallischen Binder beziehungsweise eine entsprechende metallische Matrix umfasst. Als metallische Matrix werden üblicherweise Cobalt, Nickel und/oder Eisen eingesetzt. Als weitere Carbide können Carbide von Metallen der vierten (Titangruppe), fünften (Vanadiumgruppe) und sechsten (Chromgruppe) Nebengruppe, also beispielsweise von Tantal, Niob, Hafnium, Zirkon, etc., verwendet werden.

Unter Cermets werden Verbundwerkstoffe verstanden, die bezüglich der Carbide Titancarbid als Hauptphase enthalten. Typischerweise wird der Hauptanteil des Binders durch Nickel und/oder Cobalt gebildet.

Unter Hartstoffen versteht man Werkstoffe mit einer Härte von mehr als 10 GPa.

Werkzeugstähle wiederum sind nach DIN 17300 Stähle, welche durch ihre Anwendung in Werkzeugen definiert werden.

Bei den Beschichtungsverfahren kann die Beschichtung der entsprechenden Substrate zur Herstellung der Zerspanwerkzeuge auf chemischem oder auf physikalischem Wege erfolgen. Entsprechende Beschichtungsverfahren sind das CVD-Verfahren, welches auch als chemische Gasphasenabscheidung (englisch: chemical vapour deposition) bekannt ist, sowie das PVD-Verfahren, welches auch als physikalische Gasphasenabscheidung (englisch: physical vapour deposition), bekannt ist. Im Nachfolgenden wird nur das PVD-Verfahren betrachtet.

Als Verfahren der PVD sind unter anderem thermisches Verdampfen, Elektronenstrahlverdampfen, Magnetronsputtern, Laserstrahlverdampfen und lichtbogenverdampfen bekannt. Allen Verfahren der PVD ist gemein, dass das abzuscheidende Material in fester Form in der evakuierten Beschichtungskammer vorliegt. Durch den Beschuss beispielsweise mit Laserstrahlen, magnetisch abgelenkten Ionen oder Elektronen oder durch Lichtbogenentladung wird das Material, das als Beschichtungsquelle bzw. Target bezeichnet wird, verdampft. Wie hoch der Anteil an Atomen, Ionen oder größeren Clustern im Dampf ist, ist von Verfahren zu Verfahren unterschiedlich.

Das verdampfte Material bewegt sich entweder ballistisch oder durch elektrische Felder geführt durch die Kammer und trifft dabei auf die zu beschichtenden Teile, wo es zur Schichtbildung kommt.

Treffen die verdampften Materialien auf das Substrat, beginnen sie sich durch Kondensation an der Oberfläche des Substrats abzulagern. Die Teilchen bleiben dabei nicht an dem Ort, an dem sie auf das Substrat treffen, sondern bewegen sich, je nachdem wie hoch ihre Energie ist, an der Oberfläche entlang (Oberflächendiffusion), um einen energetisch günstigeren Platz zu finden. Dies sind Stellen an der Kristalloberfläche mit möglichst vielen atomaren Nachbarn (höhere Bindungsenergie).

Mit den verschiedenen PVD-Varianten können fast alle Metalle und auch Kohlenstoff in sehr reiner Form abgeschieden werden. Führt man dem Prozess Reaktivgase wie Sauerstoff, Stickstoff oder Kohlenwasserstoffe zu, lassen sich auch Oxide, Nitride oder Carbide abscheiden.

Es ist aus Cekada et al. (Vakuum 52, 1999/461-467) bekannt, eine CrTaN-Hartstoffbeschichtung mittels PVD mit Zusammensetzungen von Cr_{0,58}Ta_{0,42}N oder Cr_{0,17} Ta_{0,83}N auf ein Substrat aufzubringen. Die Beschichtungen zeigten eine kubische Struktur und eine gute Oxidationsbeständigkeit. In der Veröffentlichung wird der Schluss gezogen, dass weder die chromreiche Cr_{0,58}Ta₀,₄₂N-Beschichtung, noch die tantalreiche Cr_{0,17}Ta_{0,83}N-Beschichtung irgendwelche Vorteile gegenüber herkömmlichen CrN- oder TaN-Binärbeschichtungen aufweisen würde.

Chen et al. untersuchten einlagige, kristalline Ta₄₈N₅₂- und Cr₂₃Ta₂₇N₅₀-Beschichtungen sowie nahezu amorphe Ta₂₂Si₁₉N₅₉- und Cr₆Ta₂₅Si₁₁N₅₈-Beschichtungen, welche unter Verwendung eines Co-Sputtering-Prozesses auf einem Siliziumsubstrat aufgebracht wurden. (Y. L.Chen, et al. Surface and Coatings Technology (2014) http://dx.doi.org/10.1016/j.surfcoat.2014.02.005) Chen et al. (Surface and Coatings Technology 2006/2011 / 1640-1647) haben weiterhin einschichtige CrTaN-Beschichtungen auf WC Substraten unter Verwendung von reaktivem Magnetronsputtering ohne Erhitzung der Substrate abgeschieden. Die CrTaN-Schichten wiesen kubische (fcc)-Strukturen mit (111) Vorzugsorientierung auf. Gemäß der Veröffentlichung eignet sich die Schicht gut als Oxidationsschutz für Glasschmelzwannen oder Zerspanwerkzeuge.

Das Patentdokument US 2014/272391 A1 offenbart auch ein beschichtetes Schneidwerkzeug sowie ein Verfahren zu dessen Herstellung, wobei die Beschichtung aus mehreren nanolagenartig gestapelten MeAIN-Schichten besteht, wobei Me Ti und/oder Cr bedeutet.

### Darstellung der Erfindung

Ausgehend von dem bekannten Stand der Technik ist es eine Aufgabe der vorliegenden Erfindung, ein Verfahren zur Herstellung einer Hartstoffschicht auf einem Substrat, sowie ein Zerspanwerkzeug mit weiter verbesserten Eigenschaften bezüglich der Verschleißfestigkeit und der Härte anzugeben.

Diese Aufgabe wird durch ein Verfahren mit den Merkmalen des Anspruchs 1 und ein Zerspanwerkzeug mit den Merkmalen des Anspruchs 13 gelöst. Vorteilhafte Weiterbildungen ergeben sich aus den Unteransprüchen. Entsprechend wird ein Verfahren zur Herstellung einer Hartstoffschicht auf einem Substrat vorgeschlagen, wobei erfindungsgemäß auf dem Substrat mittels physikalischer Gasphasenabscheidung (PVD) ein Mehrlagenschichtensystem durch alternierende Abscheidung von CrTaN und AlTiN aufgebracht wird, wobei AlTiN in einer atomaren Zusammensetzung von AlₓTi₁₋ₓN mit 0,2≤x≤0,9 und CrTaN mit einer atomaren Zusammensetzung von Cr_{1-y}Ta_{y}N mit 0,01≤y≤0,65, aufgebracht wird, gemessen mit GDOES oder EDX, wobei die einzelnen Schichten des Mehrlagenschichtensystems in Dicken zwischen 5 und 200 Nanometern aufgebracht und 10 bis 5000 Schichten altemierend abgeschieden werden.

Gegenüber den aus dem Stand der Technik bekannten Verfahren zum Herstellen von Hartstoffschichten, insbesondere den CrTaN-Hartstoffschichten, kann durch das durch alternierende Abscheidung von CrTaN und AlTiN aufgebaute Mehrlagenschichtensystem eine deutliche Härtesteigerung der auf diese Weise abgeschiedenen Hartstoffschicht erreicht werden. Dies wirkt sich positiv auf die Verschleißeigenschaften im Vergleich zu den im Stand der Technik diskutierten CrTaN Einzellagen aus. Auch gegenüber dem Aufbau eines Zweischichtensystems aus CrTaN und AlTiN kann eine deutliche Härtesteigerung erreicht werden.

Es ist bekannt, dass einlagige Hartstoffbeschichtungen aus reinem CrTaN einen niedrigen Reibwert aufweisen, so dass hier prinzipiell eine gute Eignung für Schneid- und Zerspanwerkzeuge vorliegt. Es ist jedoch auch bekannt, dass die Verschleißbeständigkeit einer Hartstoffschicht aus reinem CrTaN nicht sehr hoch ist.

Durch den vorgeschlagenen Aufbau des Mehrlagenschichtensystems aus CrTaN und AlTiN, kann hingegen eine deutliche Härtesteigerung erreicht werden, so dass die Eignung der auf diese Weise hergestellten Hartstoffschicht für ein Schneid- und Zerspanwerkzeug deutlich verbessert wird. Weiterhin kann durch das Mehrlagenschichtensystem aus CrTaN und AlTiN ein reduzierter Reibwert gegenüber reinen AlTiN-Schichten erreicht werden, so dass sich verbesserte Eigenschaften beim Einsatz in Schneid- und Zerspanwerkzeugen ergeben.

Weiterhin hat sich ergeben, dass durch das Abscheiden des Mehrlagenschichtensystems der thermische Zerfall von CrTaN in GraN bzw. Ta₂N, so wie er bei einer einlagigen Schicht auftreten würde und wie er in der Literatur beschrieben ist, weitgehend unterdrückt wird. Dies führt zu einer besonderen Eignung der auf die genannte Weise hergestellten Hartstoffschichten für einen Hochtemperatureinsatz. Entsprechend eignet sich das vorgestellte Verfahren zur Herstellung einer Hartstoffschicht und die daraus resultierende Hartstoffschicht nicht nur für den Einsatz als Verschleißschutzschicht auf Werkzeugen, beispielsweise auf Hartmetallwendeschneidplatten oder Vollhartmetallwerkzeugen, sondern kann beispielsweise auch als Oxidationsschutz für Elemente von Glasschmelzwannen herangezogen werden.

Es hat sich weiterhin ergeben, dass die altemierend aufgebrachten CrTaN-Lagen die kubische Kristallstruktur der AlTIN-Lagen stabilisieren, so dass über die beschriebene Herstellung des Mehrlagenschichtensystems entsprechend eine weitgehend stabile kubische Kristallstruktur ausgebildet werden kann.

Das Verfahren ist bevorzugt so ausgestaltet, dass CrTaN unter Zusatz von Stickstoff aus einem Composite-Target abgeschieden wird, bevorzugt aus einem Composite-Target mit einem Ta Gehalt von 1-60 at.-%, besonders bevorzugt einem Ta Gehalt von 20-30 at.-%, besonders bevorzugt einem Ta Gehalt von 25 at.-%.

Weiterhin bevorzugt ist eine Ausgestaltung des Verfahrens dahingehend, dass AlTiN unter Zusatz von Stickstoff aus einem Composite-Target abgeschieden wird, bevorzugt aus einem Composite-Target mit einem Ti Gehalt von 10-80 at.-%, besonders bevorzugt einem Ti Gehalt von 25-50 at.-%, besonders bevorzugt einem Ti Gehalt von 40 at.-%.

Durch die genannte Abscheidung von CrTaN und/oder AlTiN aus einem Composite-Target kann - neben der Ausbildung einer stabilen kubischen Kristallstruktur - auch ein jeweils einphasiges Abscheiden der jeweiligen CrTaN und/oder AlTiN Schichten erreicht werden, was sich vorteilhaft auf die Standzeit auswirkt.

Durch die Verwendung von Composite-Targets kann auch auf das aufwändigere Co-Sputtem mit mehreren Targets verzichtet werden, so dass ein effizienterer Beschichtungsvorgang erreicht werden kann.

In dem Mehrlagenschichtensystem wird AlTiN bevorzugt in einer atomaren Zusammensetzung von AlₓTi₁₋ₓN mit bevorzugt 0,4≤x≤0,8, besonders bevorzugt 0,5≤x≤0,7, auf dem Substrat aufgebracht. Die Schichtzusammensetzung wird bevorzugt über Glimmentladungsspektroskopie (engl. Glow Discharge Optical Emission Spectroscopy - im Folgenden als GDOES bezeichnet) oder Energiedispersive Röntgenspektroskopie (engl. Energy Dispersive X-ray Spectroscopy - im Folgenden als EDX bezeichnet) gemessen.

In dem Mehrlagenschichtensystem wird CrTaN bevorzugt mit einer atomaren Zusammensetzung von Cr_{1-y}Ta_{y}N mit bevorzugt 0,2≤y≤0,4, besonders bevorzugt 0,25≤y≤0,35, auf dem Substrat aufgebracht, gemessen mit GDOES oder EDX.

Die genannten Zusammensetzungen von CrTaN und AlTiN führen zu einem besonders harten, eine stabile kubische Kristallstruktur ausbildenden Mehrlagenschichtensystem zur Ausbildung einer Hartstoffschicht.

Unter einem Mehrlagenschichtensystem wird hier ein solches System verstanden, bei welchem altemierend CrTaN- und AlTiN-Schichten mittels PVD auf das Substrat aufgebracht werden. Dabei werden bevorzugt die einzelnen Schichten des Mehrlagenschichtensystems in Dicken zwischen zwischen 10 und 100 Nanometem, besonders bevorzugt von 15 Nanometern abgeschieden.

Bevorzugt werden in dem Mehrlagenschichtensystem 25 bis 1000, besonders bevorzugt 50 bis 250 Schichten altemierend abgeschieden. Auf diese Weise kann eine stabile Hartstoffschicht abgeschieden werden, die gleichzeitig ein effizientes Herstellen der gesamten Hartstoffschicht ermöglicht.

Durch die oben angegebenen Schichtdicken und Anzahlen der Schichten wird ein effizientes Verhältnis bereitgestellt aus Härte, Stabilität, Verschleißfestigkeit und Standzeit der Hartstoffschicht einerseits, sowie der Anforderung an eine kurze Prozessdauer und damit ein kosteneffizientes Herstellen der Hartstoffschicht andererseits.

Als Substratwerkstoffe werden bevorzugt Hartmetalle, Cermets, Hartstoffe oder Werkstoffstähle verwendet, wobei das Substrat vor dem Aufbringen der jeweiligen Beschichtung bevorzugt vorbehandelt wird.

In einer alternativen Ausgestaltung des Verfahrens wird in dem Mehrlagenschichtensystem anstelle von AlTiN mindestens eine Schicht AlTiXN altemierend mit CrTaN abgeschieden, wobei X=Ta, V, Si, Mo oder Hf, und wobei AlTiXN bevorzugt aus einem Composite-Target abgeschieden wird.

Durch den zusätzlichen Einbau von Ta, V, Si, Mo oder Hf können die Materialeigenschaften der Hartstoffschicht weiter variiert werden, wobei die grundsätzlichen vorteilhaften Eigenschaften, die oben beschrieben wurden, weiterhin erhalten bleiben.

Bevorzugt wird auf dem Substrat zunächst mittels physikalischer Gasphasenabscheidung (PVD) eine AlTIN-Grundschicht abgeschieden, bevorzugt in einer Dicke von 0,5 bis 10 µm, besonders bevorzugt 1 bis 5 µm, ganz besonders bevorzugt von 2 µm, und auf dieser AlTiN Grundschicht das Mehrlagenschichtensystem mittels alternierender Abscheidung von CrTaN und AlTiN aufgebracht.

Die Grundschicht stellt eine Verbindungsschicht zwischen dem Substrat und dem Mehrlagenschichtensystem bereit und ermöglicht auf diese Weise eine noch bessere Haftung der Hartstoffschicht auf dem Substrat.

Alternativ kann anstelle von AlTiN eine Grundschicht aus AlTiXN abgeschieden werden, wobei X=Ta, V, Si, Mo, Hf, und wobei AlTiXN. bevorzugt aus einem Composite-Target abgeschieden wird.

Weiterhin kann auf dem Mehrlagenschichtensystem mittels physikalischer Gasphasenabscheidung (PVD) eine Deckschicht aus TiN oder CrTaN aufgebracht werden, bevorzugt mit einer Dicke von 0,1 bis 1 0 µm, bevorzugt 0,5 bis 5 µm und besonders bevorzugt 1 µm. Durch das Aufbringen der Deckschicht kann eine weitere vorteilhafte Anpassung der Eigenschaften der Hartstoffschicht erreicht werden, beispielsweise in Form einer Erhöhung des E-Moduls.

Das Mehrlagenschichtensystem, bevorzugt in Verbindung mit der jeweiligen Deckschicht, kann bevorzugt nachbehandelt werden, beispielsweise durch Nassstrahlen, Trockenstrahlen oder Färben, wobei hier bevorzugt die Oberflächenstruktur und/oder die Oberflächenrauigkeit an den jeweiligen vorgesehenen Anwendungsbereich angepasst wird.

Bevorzugt findet die Abscheidung der CrTaN-Schicht aus einem CrTa Composite-Target statt, bevorzugt aus einem CrTa Composite-Target mit einer atomaren Zusammensetzung von 75/25. Hier kann über EDX beispielsweise eine chemische Zusammensetzung der abgeschiedenen CrTaN-Schicht von Cr_{0.71}Ta_{0.29}N gemessen werden.

Die oben genannte Aufgabe wird weiterhin auch durch ein Zerspanwerkzeug mit einem Substrat aus Hartmetall gemäß Anspruch 13 gelöst. Vorteilhafte Weiterbildungen ergeben sich aus den abhängigen Ansprüchen.

Entsprechend wird ein Zerspanwerkzeug mit einem Substrat aus Hartmetall vorgeschlagen. Erfindungsgemäß ist auf dem Substrat mittels physikalischer Gasphasenabscheidung (PVD) ein Mehrlagenschichtensystem durch alternierende Abscheidung von CrTaN und AlTiN aufgebracht, wobei AlTIN in einer atomaren Zusammensetzung von AlₓTi₁₋ₓN mit 0,2≤x≤0,9 und CrTaN mit einer atomaren Zusammensetzung von Cr_{1-y}Ta_{y}N mit 0,01≤y≤0,65, aufgebracht ist, gemessen mit GDOES oder EDX, und wobei die einzelnen Schichten des Mehrlagenschichtensystems in Dicken zwischen 5 und 200 Nanometern aufgebracht und 10 bis 5000 Schichten altemierend abgeschieden sind Es ergeben sich hieraus die oben bezüglich des Verfahrens beschriebenen Vorteile des Ausbildens dieser Hartstoffschicht auf dem Substrat zur Ausbildung des Zerspanwerkzeugs. Besonders vorteilhaft ist die hohe Härte der Hartstoffschicht bei gleichzeitig relativ niedrigem Reibwert.

Vorteilhaft ist zwischen dem Substrat und dem CrTaN / AlTiN Mehrlagenschichtensystem eine AlTiN-Grundschicht vorgesehen, bevorzugt in einer Dicke von 0,5 bis 10 µm, besonders bevorzugt 1 bis 5 µm, ganz besonders bevorzugt von 2 µm.

Von Vorteil ist es weiterhin, auf dem CrTaN / AlTiN Mehrlagenschichtensystem mindestens eine Deckschicht aus TiN oder CrTaN aufzubringen, bevorzugt mit einer Dicke von 0,1 bis 10 µm, bevorzugt 0,5 bis 5 µm und besonders bevorzugt 1 µm.

Vorteilhaft ist das Substrat des Zerspanwerkzeugs vor dem Aufbringen der jeweiligen Beschichtung vorbehandelt, bevorzugt poliert.

Um eine besonders vorteilhafte Anwendbarkeit des Zerspanwerkzeugs zu erreichen, ist das CrTaN / AlTiN Mehrlagenschichtensystem bevorzugt nachbehandelt und die Oberflächenstruktur und/oder die Oberflächenrauigkeit sind an die jeweilige Anwendung angepasst, besonders bevorzugt durch Nassstrahlen, Trockenstrahlen und/oder Färben.

In dem oben beschriebenen Verfahren zur Herstellung einer Hartstoffschicht wird zur Abscheidung von CrTaN bevorzugt ein Composite-Target verwendet. Es ist ein Teil der vorliegenden Offenbarung, ein Verfahren zur Herstellung einer Beschichtungsquelle zur Durchführung des Verfahrens zur Herstellung der Hartstoffschicht, sowie eine Beschichtungsquelle anzugeben.

Diese Aufgabe wird durch ein Verfahren zur Herstellung einer Beschichtungsquelle mit den Merkmalen gemäß der Offenbarung gelöst, das nicht Teil der vorliegenden Erfindung in den Ansprüchen ist.

Entsprechend wird ein Verfahren zur Herstellung einer Beschichtungsquelle zur physikalischen Gasphasenabscheidung (PVD) von CrTaN vorgeschlagen, das nicht Teil der vorliegenden Erfindung In den Ansprüchen Ist, wobei eine Pulvermischung aus reinem Cr Pulver und reinem Ta Pulver bereitgestellt wird und die Beschichtungsquelle durch heißes Verdichten der Pulvermischung geformt wird.

Auf diese Weise lässt sich einfach eine Beschichtungsquelle zum Abscheiden von CrTaN in einer PVD Anlage bereitstellen, mittels welcher eine Abscheidung von CrTaN in einer vorgegebenen atomaren Zusammensetzung erreicht werden kann, wobei die resultierende Schicht eine stabile kubische Kristallstruktur aufweist und einphasig ausgebildet ist.

Bevorzugt wird die Pulvermischung vor dem heißen Verdichten mit einem Ta Gehalt von 1-60 at.-%, besonders bevorzugt einem Ta Gehalt von 20-30 at.-%, ganz besonders bevorzugt mit einem Ta Gehalt von 25 at.-% bereitgestellt. Auf diese Weise können die als vorteilhaft erkannten Zusammensetzungen der damit abgeschiedenen Schichten erreicht werden.

Bevorzugt liegt die Komgröße des Cr Pulvers und/oder des Ta Pulvers bei Werten unter 45 µm, um eine besonders homogene Mischung der Pulvermischung zu erreichen und beim heißen Verdichten eine besonders feine Verteilung der Cr₂Ta Phase zu erreichen.

Das heiße Verdichten wird bevorzugt durch Heißpressen, Spark-Plasma-Sintern (SPS) oder heiß-isostatisches Pressen (HIP) durchgeführt und das Pulver wird während des Verpressens bevorzugt mit Hilfe von Heizleitern und/oder direkt mit einem elektrischen Strom beaufschlagt und/oder induktiv geheizt.

Um ein vorteilhaftes Gefüge der Beschichtungsquelle zu erreichen, findet das heiße Verpressen bevorzugt in einem Temperaturbereich von 1100-1750°C statt, besonders bevorzugt in einem Temperaturbereich von 1300-1500°C.

Die Behandlungszeit liegt bevorzugt unter einer Stunde, um eine Rekristallisation zu vermeiden und die Feinkörnigkeit des Gefüges beizubehalten. Bei kurzen Sinterzeiten findet weiterhin auch keine vollständige Umwandlung von Ta in die Cr₂Ta Phase statt, so dass in dem resultierenden Gefüge der Beschichtungsquelle drei Phasen vorhanden sind, nämlich eine reine Ta Phase, eine reine Cr Phase und die Cr₂Ta Phase.

### Kurze Beschreibung der Figuren

Bevorzugte weitere Ausführungsformen und Aspekte der vorliegenden Erfindung werden durch die nachfolgende Beschreibung der Figuren näher erläutert.

Dabei zeigen:
- Figur 1: eine Darstellung der Messwerte für die Nanohärte H und den E-Modul E unterschiedlicher CrTaN-Schichtsysteme,
- Figur 2: ein REM (Rasterslektronenmikroskopie) -Bruchbild eines Schichtsystems auf einem Substrat mit einer AlTiN-Grundschicht und einem AlTiN/CrTaN-Mehrlagenschichtensystem,
- Figur 3: eine Darstellung der Messwerte eines Zerspanungstests,
- Figur 4: eine metallographische Schnittdarstellung mit einer Korngrenzätzung einer Beschichtungsquelle in Form eines CrTa Composite-Targets, und
- Figur 5: ein Phasendiagramm des Gefüges des CrTa Composite-Targets.

### Detaillierte Beschreibung bevorzugter Ausführungsbeispiele

Im Folgenden werden bevorzugte Ausführungsbeispiele anhand der Figuren beschrieben. Dabei werden gleiche, ähnliche oder gleichwirkende Elemente mit identischen Bezugszeichen bezeichnet und auf eine wiederholte Beschreibung dieser Elemente wird teilweise verzichtet, um Redundanzen in der Beschreibung zu vermeiden.

Auf einem Substrat wird zur Herstellung einer Hartstoffschicht mittels physikalischer Gasphasenabscheidung (PVD) ein Mehrlagenschichtensystem durch alternierende Abscheidung von CrTaN und AlTIN aufgebracht. Die Hartstoffschicht dient beispielsweise als Verschleißschutzschicht für Schneid- oder Zerspanwerkzeuge.

Als Substrate für die genannte PVD-Beschichtung können nahezu alle verfügbaren Hartmetallsubstrate sowie Cermetsubstrate infrage kommen, weiterhin können auch sämtliche Refraktärmetalle verwendet werden, wobei die hierin beschriebenen Schichtsysteme beispielsweise auch als Oxidationsschutz für Elemente in Glasschmelzwannen denkbar sind. Die Substrate können vorbehandelt werden und insbesondere poliert, geschliffen oder gestrahlt werden, um den nachfolgenden Aufbau der Hartstoffschicht und die Maßhaltigkeit des fertig beschichteten Bauteils zu unterstützen.

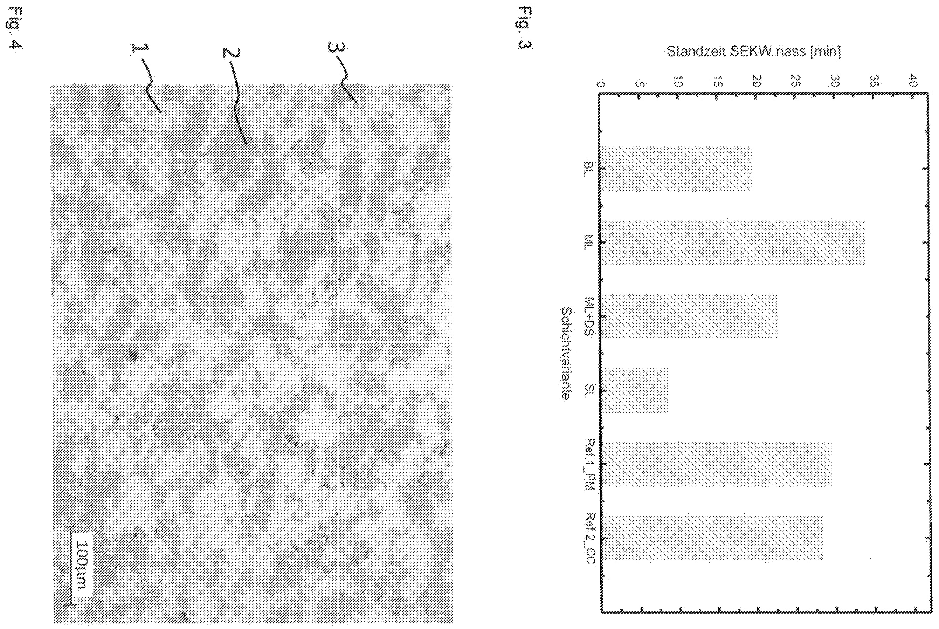

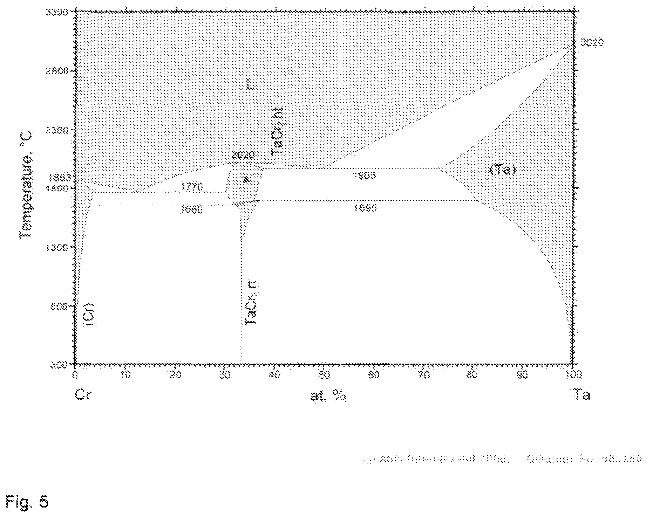

Es ist besonders bevorzugt, den Aufbau der Schichten mittels Composite-Targets, also Targets, welche eine Zusammensetzung aus mehreren unterschiedlichen Phasen aufweisen, durchzuführen. Hierbei sind beispielsweise pulvermetallurgisch hergestellte Composite-Targets heranzuziehen. Auf eine mögliche Herstellungsweise von CrTa Composite-Targets wird weiter unten zu den Figuren 4 und 5 eingegangen.

Die Beschichtungen werden beispielsweise mittels PVD-Verfahren bei Temperaturen von 400-600°C auf ein Hartmetallsubstrat aufgebracht. Die Durchführung kann beispielsweise in einer ARC-PVD-Beschichtungsantage, in einer Sputter-Anlage oder in einer HIPIMS-Anlage durchgeführt werden.

Nachfolgend werden beispielhaft Schichtsysterne vorgestellt, bei welchen CrTaN-Schichten und AlTiN-Schichten auf das Substrat aufgebracht wurden, wobei unterschiedliche Schichtenfolgen aufgebracht und dann jeweils mehrere relevante Parameter gemessen wurden,

Beispielhafte Schichtaufbauten der AlTIN und CrTaN Schichten aufweisenden Proben sind in Tabelle 1 gezeigt:

**Tabelle 1: Beispielhafte Kombinationen aus Substrat, Schicht und Nachbehandlung**

| Substrat | Schicht | Nachbehandlung |
|---|---|---|
| | AlTiN/CrTaN | |
| uneingeschränkt | AlTiN/(AlTiN/CrTaN-Mehrlagenschichtensystem) | Trocken- oder Nassstrahlen |
| | (AlTiN/CrTaN-Mehrlagenschichtensystem) | |
| | AlTiN/(AlTiN/CrTaN-Mehrlegenschichtensystem)/CrTaN | |

Um die Schichten abscheiden zu können, wurden beispielsweise die folgenden, in der nachfolgenden Tabelle 2 aufgeführten Zusammensetzungen der Targets in der PVD Anlage vorgesehen. Waren Einzellagenschichten vorgesehen, wurden sie zur Bestimmung der chemischen Zusammensetzung separat abgeschieden und die Zusammensetzung wurde mittels GDOES- bestimmt. Zur besseren Vergleichbarkeit mit der Target-Zusammensetzung ist der Stickstoff in der nachfolgenden Tabelle nicht angeführt. Es ergibt sich entsprechend bei den in der ersten Doppelspalte angegebenen Target-Zusammensetzungen die in der zweiten Spalterifolge angegebene Schichtenzusammensetzung, welche entsprechend mittels GDOES bestimmt wurde. Anstelle oder zusätzlich zu der GDOES Messung kann auch eine EDX Messung durchgeführt werden.

**Tabelle 2: Beispielhafte Targetzusammensetzung und Schichtzusammensetzung (jeweils atomar)**

| Target | | Schicht Einzellagen (GDOES) | |
|---|---|---|---|
| Ti | 100 | Ti | |
| AlTi | 60/40 | AlTi | 63/37 |
| CrTa | 75/25 | CrTa | 71/29 |

Es hat sich beim Abscheiden der Schichten als vorteilhaft ergeben, CrTaN unter Zusatz von Stickstoff von einem Composite-Target abzuscheiden, bevorzugt von einem Composite-Target mit einem Ta Gehalt von 1-60 at.-%, besonders bevorzugt einem Ta Gehalt von 20-30 at.-%, besonders bevorzugt einem Ta Gehalt von 25 at.-%.

Als besonders vorteilhafte Zusammensetzungsbereiche der Cri-yTayN Schicht ergeben sich damit 0,01≤y≤0,65, bevorzugt 0,2≤y≤0,4, besonders bevorzugt 0,25≤y≤0,35.

Die CrTaN-Schicht kann aus einem CrTa-Composite Target abgeschieden werden, was den Vorteil gegenüber dem Co-Sputtern mehrerer metallischer Targets aufweist, dass eine einphasige kubische Struktur abgeschieden wird, was beispielsweise über XRD nachgewiesen werden kann. Entsprechend ergibt sich aufgrund der Verwendung von Composite-Targets eine verbesserte Struktur der Hartstoffschicht, welche durch die Stabilisierung der kubischen Kristallstruktur erreicht wird.

Zum Abscheiden der AlTiN Schicht hat sich als vorteilhaft ergeben, AlTiN in einer Stickstoffatmosphäre aus einem Composite-Target abzuscheiden, bevorzugt aus einem Composite-Target mit einem Ti Gehalt von 10-80 at.-%, besonders bevorzugt einem Ti Gehalt von 25-50 at.-%, besonders bevorzugt einem Ti Gehalt von 40 at.-%,

Damit ergibt sich ein Zusammensetzungsbereich der AlₓTi₁₋ₓN Schicht von 0,2≤x≤0,9, bevörzugt 0,4≤x≤0,8, besonders bevorzugt 0,5≤x≤0,7. Auch hier ergibt sich durch das Abscheiden aus dem Composite-Target eine zumindest weitgehend einphasige: kubische Struktur, was beispielsweise über XRD nachgewiesen werden kann.

Für den Aufbau des Mehrlagenschichtensystems werden die einzelnen Schichten des Mehrlagenschichtensystems in Dicken zwischen 5 und 200 Nanometern, bevorzugt zwischen 10 und 100 Nanometern, besonders bevorzugt von 15 Nanometern abgeschieden. In den hier beispielhaft aufgebauten Proben lag die Dicke der Einzelschichten bei ca. 15 Nanometern,

Für den Aufbau des Mehrlagernechichtensystems werden weiterhin 10 bis 5000, bevorzugt 25 bis: 1000, besonders bevorzugt 50 bis 250 alternierende Schichten abgeschieden. In den hier aufgebauten Proben wurden ca. 100 alternierende Schichten für das Mehrlagerischichtensystem abgeschieden.

Vor diesem Hintergrund wurden die folgenden Schichtsysteme beispielhaft aufgebaut und dann vermessen:

| | |
|---|---|
| BL: | AlTiN/CrTaN Doppelschicht, wobei auf dem Substrat AlTiN mit einer Dicke von 2 µm und darauf CrTaN mit einer Dicke von 2,9 µm abgeschieden waren. |
| ML: | AlTiN-Grundschicht mit darauf aufgebautem CrTaN/AlTiN-Mehrlagenschichtensystem, wobei die AlTiN Grundschicht mit einer Dicke von 1,8 µm und das CrTaN / AlTiN Mehrlagenschichtensystem mit einer Dicke von 3 µm aufgebracht wurde. Die Einzelschichten des Mehrlagenschichtensystems hatten eine Dicke von ca. 15 nm. |
| ML+DS: | AlTiN-Grundschicht, auf der ein AlTiN/CrTaN-Mehrlagenethichtensystem aufgebaut war und darauf eine CrTaN-Deckschicht abgeschieden war, wobei die CrTaN-Deckschicht mit einer Dicke von 1,1 µm, das AlTIN/CrTaN-Mehrlagenschichtensystem mit einer Dicke von 2 µm und die Grundschicht AlTiN mit einer Dicke von 1,9 µm vorlagen. Die Einzelschichten des Mehrlagenschichtensystems hatten eine Dicke von ca. 15 nm. |
| SL: | CrTaN als Einzellage mit einer Schichtdicke von 2,5 µm CrTaN. |
| Ref.1-PM: | Referenzschicht aus AlTiN als Einzelschicht, abgeschieden aus einem 60/40 AlfTI-Composite-Target mit einer Dicke von 2,8 µm. |
| Ref.2-CC: | Referenzschicht aus AlTiN als Einzelschicht, abgeschieden aus einem 60/40 AlTiN Stopfentarget mit einer Dicke von 3 µm. |

In der nachfolgenden Tabelle 3 ist ein Schichtaufbau eines Systems aus einer AlTIN-Grundschicht mit einer darauf aufgebrachten CrTaN-Einzellage gezeigt, wobei hier entsprechend kein Mehrlagenschichtensystem gewählt ist. Dieser Aufbau entspricht der oben als BL bezeichneten Probe,

**Tabelle 3: Beispielhafter Schichtaufbau, Schichtdicke und chemische Zusammensetzung der Schicht, vom Substrat beginnend**

| Nr. | Schichtart | Schichtdicke [µm] | | | Chemische Zusammensetzung | Messverfahren |
|---|---|---|---|---|---|---|
| | | soll | min | max | | |
| 2 | CrTaN | 3,0 | 0,5 | 7,0 | (Cr_{0.71}Ta_{0.29})N | EDX |
| 1 | AlTiN | 2,0 | 0,5 | 7,0 | (Al_{0,63}Ti_{0,37}) N | EDX |
| Gesamtdicke | | 5 | 1,0 | 14 | | |

In der nachfolgenden Tabelle 4 wurde ein Mehrlagenschichtensystem auf eine AlTiN-Grundschicht aufgebracht, wobei in dem Mehrlagenschichtensystem die Einzellagendicke bei ca. 15 nm lag. Dieser Aufbau entspricht der oben genannten Probe ML.

**Tabelle 4: Beispielhafter Schichtaufbau, Schichtdicke und chemische Zusammensetzung der Schicht, vom Substrat beginnend**

| Nr. | Schichtart | Schichtdicke [µm] | | | Chemische Zusammensetzung | Messverfahren |
|---|---|---|---|---|---|---|
| | | soll | min | max | | |
| 2 | CrTaN/AlTiN | 3,0 | 0,5 | 7,0 | | |
| 1 | AlTiN | 2,0 | 0,5 | 7,0 | (Al_{0,63}Ti_{0,37}) N | EDX |
| Gesamtdicke | | 5 | 1,0 | 14 | | |

Schließlich wurde noch eine Hartstoffschicht auf dem Hartmetallsubstrat mit einer CrTaN-Deckschicht, einem CrTaN/AlTiN Mehrlagenschichtensystem und einer AlTiN Grundschicht aufgebaut, wobei sich der Aufbau aus der nachfolgenden Tabelle 5 ergibt. Dieser Aufbau entspricht der oben genannten Probe ML+DS.

**Tabelle 5: Beispielhafter Schichtaufbau, Schichtdicke und chemische Zusammensetzung der Schicht, vom Substrat beginnend**

| Nr. | Schichtart | Schichtdicke [µm] | | | Chemische Zusammensetzung | Messverfahren |
|---|---|---|---|---|---|---|
| | | soll | min | max | | |
| 3 | CrTaN | 1,0 | 0,1 | 4,0 | (Cr_{0,71}Ta_{0,29})N | EDX |
| 2 | CrTaN/AlTiN | 2,0 | 0,5 | 5,0 | | |
| 1 | AlTiN | 2,0 | 0,5 | 7,0 | (Al_{0,63}Ti_{0,37}) N | EDX |
| Gesamtdicke | | 5 | 1,1 | 16 | | |

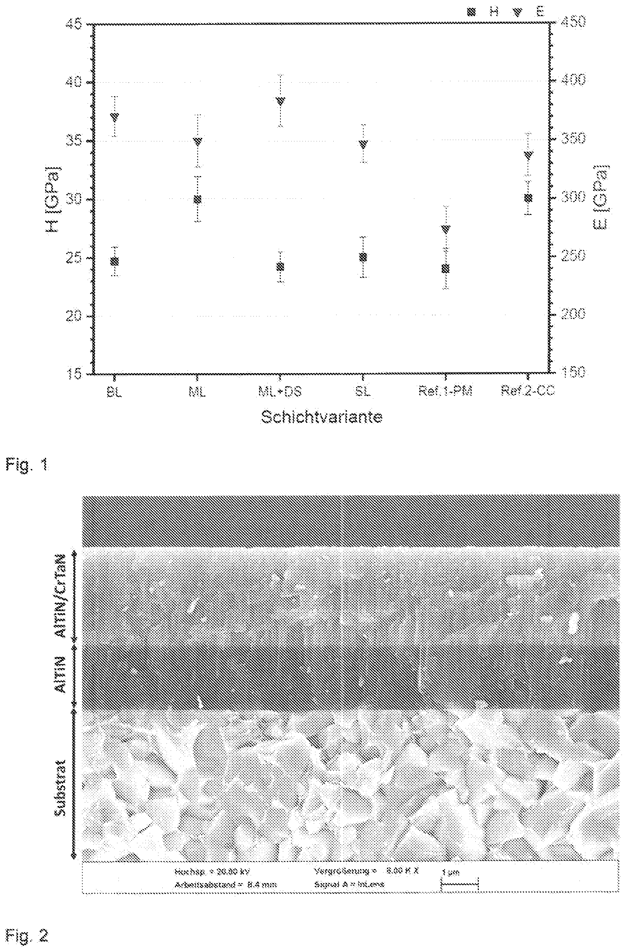

Figur 1 zeigt Werte der Nanohärte H und des E-Moduls E bei unterschiedlichen, zumindest eine CrTaN Schicht aufweisenden Schichtsystemen.

Die Nanohärte wurde hier mittels eines Nanoidenters (Ultra-Micro-Indentation System - UMIS) gemessen, der einen Berkovich Diamant Eindringkörper aufwies. Es wurden jeweils 16 Eindrücke je Probe für die Messungen durchgeführt und dabei die Nanohärte und der E-Modul bestimmt.

Aus der Figur 1 ergibt sich sofort, dass sich gegenüber der Einzelschicht SL und der Doppelschicht BL, die jeweils eine CrTaN Schicht umfassten, durch die Verwendung des Mehrlagenschichtensystems ML eine deutliche Härtesteigerung ergab. Ausgehend von den SL und BL Proben, die eine Nanohärte von 16,0 bis 15,5 GPa aufwiesen, steigerte sich die Nanohärte bei den ML Proben auf ca. 25 bis 30 GPa.

Aus den in Figur 1 gezeigten Ergebnissen ergibt sich, dass das Mehrlagenschichtensystem ML eine höhere Härte und damit auch verbesserte Verschleißeigenschaften gegenüber den Einzelschichten SL und Doppelschichten BL aufweist.

Auch gegenüber den AlTiN Schichten, insbesondere den Ref. 1-PM und Ref. 2-CC Schichten, kann eine höhere Nanohärte erreicht werden, wie sich ebenfalls aus der Figur 1 ergibt.

Der Aufbau eines Mehrlagenschichtensystems aus CrTaN und AlTIN ergibt also eine Härtesteigerung gegenüber den Einzelschichten oder einer Doppelschicht aus diesen Materialien.

Weiterhin ergibt sich, dass in dem Mehrlagenschichtensystem der thermische Zerfall des CrTaN in Cr₂N und Ta₂N, wie er beispielsweise bei einlagigen Schichten auftreten würde und wie er in der Literatur beschrieben ist, weitgehend unterdrückt wird. Entsprechend ergibt sich aus dem vorgeschlagenen Mehrlagenschichtensystem ein solches, welches auch eine besondere Eignung im Hochtemperatureinsatz aufweist. Bei dem Mehrlagenschichtensystem ergibt sich, dass aufgrund der Stabilisierung der kubischen Kristallstruktur der thermische Zerfall verhindert wird, so dass die aufgebrachte Schicht entsprechend auch temperaturstabil ist, wodurch längere Standzeiten ermöglicht werden. Dieses Eigenschaftsprofil ist entsprechend für den Einsatz als Verschleißschutzschicht auf Hartmetallwendeschneidplatten sowie auch in Vollhartmetallwerkzeugen verwendbar.

Weiterhin konnte ein geringer Reibwert des Mehrlagenschichtensystems ML im Tribometer-Versuch (bei Raumtemperatur, 500°C und 700°C) festgestellt werden.

Hierzu wurde ein Tribometer des Herstellers CSM Instruments in Kugel-Scheibe Konfiguration mit einem Gegenkörper aus Al₂O₃ mit einem Durchmesser von 6 mm verwendet und Messungen bei Raumtemperatur (RT), 500°C und 700°C durchgeführt. Die eingestellte Last lag bei 5N, der Gleitweg bei 300 m, und die Geschwindigkeit bei 10 cm/s. Der Radius des Verschfeißgrabens lag bei 5 mm. Vermessung des Verschleißgrabens wurde mittels eines Veeco Weißlichtprofilometers durchgeführt und dabei ein 2D Querschnitt und eine 3D Darstellung erstellt.

Die Messungen an den genannten Proben sind in der Tabelle 6 unten dargestellt. Es ergibt sich sofort, dass die erreichbaren Reibwerte (Reibkoeffizient µ) für das Mehrlagenschichtensystem ML s 0,7 sind, bestenfalls sogar s 0,6. Entsprechend ist die Probe mit dem Mehrlagenschichtensystem ML besonders geeignet für die Anwendung in Werkzeugen, in welchen die Reibwerte niedrig sein müssen, wie beispielsweise bei Gewindewerkzeugen, Reibahlen und Vollmetallwerkzeugen.

**Tabelle 6: Gemessene Reibkoeffizienten und Verschleißkoeffizienten**

| Bezeichnung | Schichtdicke [µm] | Reibkoeffizient µ ∼] | | | Verschleißkoeffizient K [m³/(Nm)] | | |
|---|---|---|---|---|---|---|---|
| | | RT | 500°C | 700°C | RT | 500°C | 700°C |
| BL | 212,0 | 0,71 | 0,66 | 0,60 | 1,27*10⁻¹⁵ | 1,55*10⁻¹⁴ | 1,65°10⁻¹⁴ |
| : ML | 1,8/3 | 0,67 | 0,57 | 0,56 | 1,67*10⁻¹⁵ | 6,67*10⁻¹⁵ | 1,25*10⁻¹⁴ |
| ML+DS | 1,9/2/1,1 | 0,60 | 0,58 | 0,58 | 1,14*10⁻¹⁵ | 9,70*10⁻¹⁵ | 1,45*10⁻¹⁴ |
| SL | 2,4 | 0,61 | 0,59 | 0,51 | 1,81*10⁻¹⁵ | 9,32*10⁻¹⁵ | 8,19*10⁻¹⁵ |
| Ref. 1-PM | 2,8 | 0,85 | 0,96 | 0,86 | 2.28*10⁻¹⁴ | 5,37*10⁻¹⁶ | 4,60*10⁻¹⁵ |
| Ref. 2-CC | 3 | 0,88 | 1,02 | 0,88 | 1,87*'10⁻¹⁴ | 5,79*10⁻¹⁶ | 4,45*10⁻¹⁵ |

Weiterhin wurden die Eigenspannungszustände der Schichtsysteme in der nachfolgenden Tabelle 7 aufgelistet. Die Spannungen wurden dabei im "as deposited"-Zustand über die Wafer Curvature Methode an Siliziumproben bestimmt. Abhängig von der Herstellungsmethode der Schichten können diese Werte allerdings variieren.

**Tabelle 7: Schichteigenspannungen gemessen über Wafer Curvature Methode an Si Proben**

| Bezeichnung | Schicht | Spannungen [MPa] |
|---|---|---|
| BL | TiAIN / TaCrN | ∼ -370 |
| ML | TiAIN / TiAlN TaCrN | ∼ -450 |
| ML+DS | TiAlN / TiAlN TaCrN / TaCrN | - -450 |
| SL | TaCrN | ∼ -500 |
| Ref. 1-PM | TlAIN PM-Targets | ∼ -550 |
| Ref.2-CC | TlAIN Stopfentargets | ~ -1200 |

Es ergibt sich, dass das Mehrlagenschichtensystem ML auch relativ niedrige Schichteigenspannungen aufweist, wodurch die Lebensdauer und die Standzeit weiter positiv beeinflusst wird.

Ein beispielhafter Aufbau eines Mehrlagenschichtensystems ML ist in Figur 2 im Bruchbild gezeigt, wobei eine AlTIN-Grundschicht auf einem Hartmetallsubstrat vorgesehen war, auf welche dann das AlTIN/CrTaN-Mehrlagenschichtensystem aufgebracht war.

Für das oben beschriebene Mehrlagenschichtensystem ML kommt es entsprechend zu einer massiven Härtesteigerung bei gleichzeitig niedrigen Reibwerten und einer hohen Standzeit.

Bei der Verwendung eines Mehrlagenschichtensystems ML wurde in Zerspanungsversuchen nachgewiesen, dass eine Beschichtung für Gewindewerkzeuge, Reibahlen und Vollhartmetallwerkzeuge besonders vorteilhaft ist, nämlich überall dort, wo der Reibwert niedrig sein soll und gleichzeitig eine große Härte gefordert ist.

In Figur 3 werden die Messergebnisse von Zerspanungstests für die unterschiedlichen Mehrlagenschichtsysteme dargestellt. Dabei wird die Standzeit eines Schneideinsatzes eines Fräsers beim Nassfräsen in Minuten angegeben. Der Zerspanungstest wurde konkret mit den folgenden Versuchsparametern durchgeführt:
Gleichlauffräsen mit einem Einzahn, wobei in der Blockebene spiralförmig abgezeilt wurde. Als Werkstoff wurde SP300 Hochleistungsstahl verwendet und das Werkzeug war ein ISCAR F45ST D050-22 zur Aufnahme von Wendeschneidplatten, das in einer SK50 Werkzeugaufnahme geführt war, Das Werkstück hatte jeweils Abmessungen von 400x200x96 mm und eine Festigkeit von 1000N/mm² Der Fräser hatte einen Durchmesser von 50mm und wurde bei einem Anstellwinkel von 45° mit einer Schnittgeschwindigkeit v_{c} von 250m/min (trocken) und 150m/min (nass), einem Zahrivorschub fₐ von 0,25mm und einer Eingriffsbreite aₑ von 32mm. vorgetrieben.

Aus der Figur 3 ergibt sich sofort, ddass das Mehrlagenschichtsystem ML die beste Standzeit aufweist. Bei der Nassbearbeitung ergibt sich eine um ca. 20% verbesserte Standzeit gegenüber den Referenzschichtsystemen. Bei der in der Figur nicht gezeigten Trockenbeärbeitung ist das Mehrlagenschichtsystem ML gegenüber den Referenzschichtsytemen allerdings nicht signifikant besser. Weiterhin kann auch ein Zerspanwerkzeug für eine Zerspanvorrichtung hergestellt werden, welches ein geeignetes Substrat, bevorzugt ein Hartmetallsubstrat, in der vorgegebenen Geometrie aufweist. Das Zerspanwerkzeug kann beispielsweise in Form eines Schneidkörpers für Dreh- und Fräsvorrichtungen oder in Form einer Wendeschneidplatte vorgesehen sein.

Auf dieses Substrat wird dann mit dem oben angegeben Verfahren eine Hartstoffschicht mit einem Mehrlagerrschfählensystem aus CrTaN und altemierend dazu AlTiN bei geringen Schichtdicken aufgebracht,

Weiterhin kann, um eine Anpassung der Oberflächenstruktur und/oder der Oberflächenrauigkeit an die jeweilige Anwendung zu erreichen, die Hartstoffschicht einer Nachbehandlung unterzogen werden. Diese Nachbehandlung kann beispielsweise durch Nassstrahlen, Trockenstrahlen und/oder Färben durchgeführt werden. Auch eine eventuell aufgebrachte Deckschicht und/oder Funktionsschicht kann einer solchen Nachbehandlung unterzogen werden.

Nachfolgend wird auf die Herstellung von Beschichtungsquellen in Form von CrTa Composite-Targets die nach den Ansprüchen nicht zur vorliegenden Erfindung gehören, und wie sie vorteilhaft in den oben beschriebenen Verfahren zur Herstellung von Hartstoffschichten zur Abscheidung der CrTaN Schichten durch PVD eingesetzt wurden.

Zur Herstellung der Composite-Targets werden zunächst reines Cr und reines Ta Puver als Rohstoffe bereitgestellt, Bevorzugt liegt die Korngröße der Pulver jeweils unter 45µm. Die beiden Pulver werden im gewünschten Verhältnis des aus dem Pulver herzustellenden CrTa Composite-Targets und möglichst homogen miteinander gemischt. Durch die feine Korngröße kann die Mischung der beiden Pulver besonders homogen bereitgestellt werden und beim nachfolgenden Verdichtungsprozess kann sich eine TaCr₂-Phase fein verteilt im Target ausbilden.

Wie bereits oben beschrieben, ist in der Mischung des herzustellenden CrTa Composite-Targets bevorzugt ein Ta Gehalt von 1-60 at.%, besonders bevorzugt von 20-30 at.%, ganz besonders bevorzugt von 25 at.%, vorzusehen.

Aus der im Wesentlichen homogenen Pulvermischung wird dann in einer Pressform mittels eines Sintervorgangs das CrTa Composite-Target hergestellt. Der Sintervorgang wird beispielsweise durch Heißpressen, Spark-Plasma-Sintern (SPS) oder heiß-isostatisches Pressen (HIP) durchgeführt. Es kann dabei jeweils vorgesehen sein, dass das Pulver während des Verpressens in einer Kammer mit Heizleitern oder direkt mit einem elektrischen Strom beaufschlagt und/oder induktiv geheizt wird.

Das Sintern mittels SPS oder Heißpressen zur Herstellung der CrTa Composite-Targets findet in einem Temperaturbereich von 1100-1750°C statt, bevorzugt in einem Temperaturbereich von 1300-1500°C. Die Sinterzeit wird möglichst kurz gehalten, bevorzugt unter einer Stunde, um eine Rekristallisation zu vermeiden und die Feinkörnigkeit des Gefüges zu erhalten.

In Figur 4 ist ein metallographischer Schnitt mit einer Korngrenzenätzung durch das auf diese Weise erstellte Composite-Target zu sehen. Nach dem Sinterprozess besteht das Gefüge aus drei Phasen, nämlich einer reinen Cr bzw. Cr-Mischkristall Phase 1, einer reinen Ta bzw. Ta Mischkristall Phase 2 und einer TaCr₂ Phase 3. Die TaCr₂ Phase 3 liegt an den Grenzflächen bei den Übergängen von Ta zu Cr vor. Um das CrTa Composite-Target in der vorgeschlagenen Weise bereitzustellen, müssen alle drei genannten Phasen vorliegen, Das zugehörige Phasendiagramm ist in Figur 5 gezeigt.

Die gemessene Dichte nach dem Sintern liegt bei mindestens 90% der theoretischen Dichte, bevorzugt bei 95% bzw. 98%.

Die auf diese Weise hergestellten CrTa Composite-Targets können entweder direkt verwendet werden, oder zur Verbesserung der Handhabung auf ihrer Rückseite an eine Rückplatte z.B. über Bonden, Hartlöten oder Diffusionsbonden befestigt werden, mittels welcher die Targets dann in der PVD Anlage zur Abscheidung von CrTaN befestigt werden können. Es können auch mehrere CrTa Composite-Targets auf eine einzige Rückplatte befestigt werden, beispielsweise um der gewünschten Geometrie in der PVD Anlage Rechnung zu tragen.

## Patentansprüche

1. Verfahren zur Herstellung einer Hartstoffschicht auf einem Substrat, **dadurch gekennzeichnet, dass** auf dem Substrat mittels physikalischer Gasphasenabscheidung (PVD) ein Mehrlagenschichtensystem durch alternierende Abscheidung von CrTaN und AlTiN aufgebracht wird, wobei AlTiN in einer atomaren Zusammensetzung von AlₓTi₁₋ₓN mit 0,2≤x≤0,9 und CrTaN mit einer atomaren Zusammensetzung von Cr_{1-y}Ta_{y}N mit 0,01≤y≤0,65, aufgebracht wird, gemessen mit GDOES oder EDX, wobei die einzelnen Schichten des Mehrlagenschichtensystems in Dicken zwischen 5 und 200 nm aufgebracht und 10 bis 5000 Schichten altemierend abgeschieden werden.

2. Verfahren gemäß Anspruch 1, wobei das Verfahren zur Herstellung eines Zerspanwerkzeugs ausgebildet ist.

3. Verfahren gemäß Anspruch 1 oder 2, **dadurch gekennzeichnet, dass** CrTaN aus einem Composite-Target abgeschieden wird, bevorzugt aus einem Composite-Target mit einem Ta Gehalt von 1-60 at.-%, besonders bevorzugt einem Ta Gehalt von 20-30 at.-%, besonders bevorzugt einem Ta Gehalt von 25 at.-%.

4. Verfahren gemäß Anspruch 1, 2 oder 3, **dadurch gekennzeichnet, dass** AlTIN aus einem Composite-Target abgeschieden wird, bevorzugt aus einem Composite-Target mit einem Ti Gehalt von 10-80 at.-%, besonders bevorzugt einem Ti Gehalt von 25-50 at.-%, besonders bevorzugt einem Ti Gehalt von 40 at.-%.

5. Verfahren gemäß einem der vorstehenden Ansprüche,
**dadurch gekennzeichnet, dass** AlTiN in einer atomaren Zusammensetzung von AlₓTi₁₋ₓN mit bevorzugt 0,4≤x≤0,8, besonders bevorzugt 0,5≤x≤0,7, auf dem Substrat aufgebracht wird, gemessen mit GDOES oder EDX.

6. Verfahren gemäß einem der vorstehenden Ansprüche,
**dadurch gekennzeichnet, dass** CrTaN mit einer atomaren Zusammensetzung von Cr_{1-y}Ta_{y}N mit bevorzugt 0,2≤y≤0,4, besonders bevorzugt 0,25≤y≤0,35, auf dem Substrat aufgebracht wird, gemessen mit GDOES oder EDX.

7. Verfahren gemäß einem der vorstehenden Ansprüche, **dadurch gekennzeichnet, dass** die einzelnen Schichten des Mehrlagenschichtensystems in Dicken bevorzugt zwischen 10 und 100 nm, besonders bevorzugt von 15 nm abgeschieden werden.

8. Verfahren gemäß einem der vorstehenden Ansprüche, **dadurch gekennzeichnet, dass** bevorzugt 25 bis 1000, besonders bevorzugt 50 bis 250 Schichten altemierend im Mehrlagenschichtensystem abgeschieden werden.

9. Verfahren gemäß einem der vorstehenden Ansprüche, **dadurch gekennzeichnet, dass** in dem Mehrlagenschichtensystem anstelle von AlTiN mindestens eine Schicht AlTiXN altemierend mit CrTaN abgeschieden wird, wobei X=Ta, V, Si, Mo oder Hf, und wobei AlTiXN bevorzugt aus einem Composite-Target abgeschieden wird.

10. Verfahren gemäß einem der vorstehenden Ansprüche, **dadurch gekennzeichnet, dass** auf dem Substrat zunächst mittels physikalischer Gasphasenabscheidung (PVD) eine AlTiN-Grundschicht abgeschieden wird, bevorzugt in einer Dicke von 0,5 bis 10 µm, besonders bevorzugt 1 bis 5 µm, besonders bevorzugt von 2 µm, und auf dieser AlTIN Grundschicht das Mehrlagenschichtensystem mittels alternierender Abscheidung von CrTaN und AlTiN Schichten aufgebracht wird.

11. Verfahren gemäß Anspruch 10, **dadurch gekennzeichnet, dass** anstelle von AlTiN eine Grundschicht aus AlTiXN abgeschieden wird, wobei X=Ta, V, Si, Mo, Hf, und wobei AlTiXN bevorzugt aus einem Composite-Target abgeschieden wird.

12. Verfahren gemäß einem der vorstehenden Ansprüche, **dadurch gekennzeichnet, dass** auf das Mehrlagenschichtensystem mittels physikalischer Gasphasenabscheidung (PVD) eine Deckschicht aus TiN oder CrTaN aufgebracht wird, bevorzugt mit einer Dicke von 0,1 bis 10 µm, bevorzugt 0,5 bis 5 µm und besonders bevorzugt 1 µm.

13. Zerspanwerkzeug mit einem Substrat aus Hartmetall, **dadurch gekennzeichnet, dass** auf dem Substrat mittels physikalischer Gasphasenabscheidung (PVD) ein Mehrlagenschichtensystem durch alternierende Abscheidung von CrTaN und AlTIN Schichten aufgebracht ist, wobei AlTiN in einer atomaren Zusammensetzung von AlₓTi₁₋ₓN mit 0,2≤x≤0,9 und CrTaN mit einer atomaren Zusammensetzung von Cr_{1-y}Ta_{y}N mit 0,01≤y≤0,65, aufgebracht ist, gemessen mit GDOES oder EDX, und wobei die einzelnen Schichten des Mehrlagenschichtensystems in Dicken zwischen 5 und 200 nm aufgebracht und 10 bis 5000 Schichten alternierend abgeschieden sind.

14. Zerspanwerkzeug nach Anspruch 13, **dadurch gekennzeichnet, dass** zwischen dem Substrat und dem CrTaN / AlTiN Mehrlagenschichtensystem eine AlTiN-Grundschicht vorgesehen ist, bevorzugt in einer Dicke von 0,5 bis 10 µm, besonders bevorzugt 1 bis 5 µm, besonders bevorzugt von 2 µm.

15. Zerspanwerkzeug nach Anspruch 13 oder 14, **dadurch gekennzeichnet, dass** auf dem CrTaN / AlTIN Mehrlagenschichtensystem mindestens eine Deckschicht aus TiN oder CrTaN aufgebracht ist, bevorzugt mit einer Dicke von 0,1 bis 10 µm, bevorzugt 0,5 bis 5 µm und besonders bevorzugt 1 µm.

## Claims

1. A method for producing a hard material coating on a substrate, **characterized in that** a multilayer coating system is deposited on the substrate by physical vapor deposition (PVD) through alternating deposition of CrTaN and AlTiN, wherein AlTiN is deposited with an atomic composition of AlₓTi₁₋ₓN with 0.2 ≤ x ≤ 0.9 and CrTaN is deposited with an atomic composition of Cr_{1-y}Ta_{y}N with 0.01 ≤ y ≤ 0.65, as measured by GDOES or EDX, wherein the individual layers of the multilayer coating system are deposited with thicknesses between 5 and 200 nm, and 10 to 5000 layers are deposited in alternation.

2. The method according to claim 1, wherein the method is configured for producing a cutting tool.

3. The method according to claim 1 or 2, **characterized in that** CrTaN is deposited from a composite target, preferably from a composite target having a Ta content of 1-60 at.%, more preferably a Ta content of 20-30 at.%, most preferably a Ta content of 25 at.%.

4. The method according to claim 1, 2 or 3, **characterized in that** AlTiN is deposited from a composite target, preferably from a composite target having a Ti content of 10-80 at.%, more preferably a Ti content of 25-50 at.%, most preferably a Ti content of 40 at.%.

5. The method according to any one of the preceding claims, **characterized in that** AlTiN is deposited on the substrate with an atomic composition of AlₓTi₁₋ₓN, preferably with 0.4 ≤ x ≤ 0.8, more preferably 0.5 ≤ x ≤ 0.7, as measured by GDOES or EDX.

6. The method according to any one of the preceding claims, **characterized in that** CrTaN is deposited on the substrate with an atomic composition of Cr_{1-y}Ta_{y}N, preferably with 0.2 ≤ y ≤ 0.4, more preferably 0.25 ≤ y ≤ 0.35, as measured by GDOES or EDX.

7. The method according to any one of the preceding claims, **characterized in that** the individual layers of the multilayer coating system are deposited with thicknesses preferably between 10 and 100 nm, more preferably 15 nm.

8. The method according to any one of the preceding claims, **characterized in that** preferably 25 to 1000, more preferably 50 to 250 layers are alternately deposited in the multilayer coating system.

9. The method according to any one of the preceding claims, **characterized in that**, in the multilayer coating system, at least one layer of AlTiXN is alternately deposited with CrTaN in place of AlTiN, wherein X = Ta, V, Si, Mo or Hf, and wherein AlTiXN is preferably deposited from a composite target.

10. The method according to any one of the preceding claims, **characterized in that** an AlTiN base layer is first deposited on the substrate by physical vapor deposition (PVD), preferably with a thickness of 0.5 to 10 µm, more preferably 1 to 5 µm, most preferably 2 µm, and the multilayer coating system is applied on this AlTiN base layer by alternating deposition of CrTaN and AlTiN layers.

11. The method according to claim 10, **characterized in that**, instead of AlTiN, a base layer of AlTiXN is deposited, wherein X = Ta, V, Si, Mo or Hf, and wherein AlTiXN is preferably deposited from a composite target.

12. The method according to any one of the preceding claims, **characterized in that** a top layer of TiN or CrTaN is applied onto the multilayer coating system by physical vapor deposition (PVD), preferably with a thickness of 0.1 to 10 µm, preferably 0.5 to 5 µm, and most preferably 1 µm.

13. A cutting tool comprising a substrate of cemented carbide, **characterized in that** a multilayer coating system is applied to the substrate by physical vapor deposition (PVD) through alternating deposition of CrTaN and AlTiN layers, wherein AlTiN is present with an atomic composition of AlₓTi₁₋ₓN with 0.2 ≤ x ≤ 0.9 and CrTaN is present with an atomic composition of Cr_{1-y}Ta_{γ}N with 0.01 ≤ y ≤ 0.65, as measured by GDOES or EDX, and wherein the individual layers of the multilayer coating system have thicknesses between 5 and 200 nm and 10 to 5000 layers are alternately deposited.

14. The cutting tool according to claim 13, **characterized in that** an AlTiN base layer is provided between the substrate and the CrTaN/AlTiN multilayer coating system, preferably with a thickness of 0.5 to 10 µm, more preferably 1 to 5 µm, most preferably 2 µm.

15. The cutting tool according to claim 13 or 14, **characterized in that** at least one top layer of TiN or CrTaN is applied onto the CrTaN/AlTiN multilayer coating system, preferably with a thickness of 0.1 to 10 µm, preferably 0.5 to 5 µm, and most preferably 1 µm.

## Revendications

1. Procédé de fabrication d'une couche de matière dure sur un substrat, **caractérisé en ce que** l'on applique sur le substrat, par dépôt physique en phase vapeur (PVD), un système de couches multicouche par dépôt alterné de CrTaN et d'AlTiN, AlTiN étant appliqué dans une composition atomique AlₓTi₁₋ₓN avec 0,2≤x≤0,9 et CrTaN étant appliqué dans une composition atomique Cr_{1-y}Ta_{y}N avec 0,01≤y≤0,65, mesurée par GDOES ou EDX, les couches individuelles du système de couches multicouche étant appliquées dans des épaisseurs comprises entre 5 et 200 nm et 10 à 5000 couches étant déposées en alternance.

2. Procédé selon la revendication 1, le procédé étant conçu pour la fabrication d'un outil d'usinage par enlèvement de matière.

3. Procédé selon la revendication 1 ou 2, **caractérisé en ce que** CrTaN est déposé à partir d'une cible composite, de préférence à partir d'une cible composite présentant une teneur en Ta de 1 à 60 % at., de manière particulièrement préférée une teneur en Ta de 20 à 30 % at., de manière tout particulièrement préférée une teneur en Ta de 25 % at.

4. Procédé selon la revendication 1, 2 ou 3, **caractérisé en ce qu'**AlTiN est déposé à partir d'une cible composite, de préférence à partir d'une cible composite présentant une teneur en Ti de 10 à 80 % at., de manière particulièrement préférée une teneur en Ti de 25 à 50 % at., de manière tout particulièrement préférée une teneur en Ti de 40 % at.

5. Procédé selon l'une quelconque des revendications précédentes,
**caractérisé en ce qu'**AlTiN est appliqué sur le substrat dans une composition atomique AlₓTi₁₋ₓN avec, de préférence, 0,4≤x≤0,8, de manière particulièrement préférée 0,5≤x≤0,7, mesurée par GDOES ou EDX.

6. Procédé selon l'une quelconque des revendications précédentes,
**caractérisé en ce que** CrTaN est appliqué sur le substrat dans une composition atomique Cr_{1-y}Ta_{y}N avec, de préférence, 0,2≤y≤0,4, de manière particulièrement préférée 0,25≤y≤0,35, mesurée par GDOES ou EDX.

7. Procédé selon l'une quelconque des revendications précédentes, **caractérisé en ce que** les couches individuelles du système de couches multicouche sont déposées dans des épaisseurs comprises, de préférence, entre 10 et 100 nm, de manière particulièrement préférée de 15 nm.

8. Procédé selon l'une quelconque des revendications précédentes, **caractérisé en ce que**, de préférence, 25 à 1000 couches, de manière particulièrement préférée 50 à 250 couches, sont déposées en alternance dans le système de couches multicouche.

9. Procédé selon l'une quelconque des revendications précédentes, **caractérisé en ce que**, dans le système de couches multicouche, au moins une couche d'AlTiXN est déposée en alternance avec CrTaN à la place d'AlTiN, X = Ta, V, Si, Mo ou Hf, et **en ce que** AlTiXN est de préférence déposé à partir d'une cible composite.

10. Procédé selon l'une quelconque des revendications précédentes, **caractérisé en ce que** l'on dépose d'abord sur le substrat une couche de base d'AlTiN par dépôt physique en phase vapeur (PVD), de préférence dans une épaisseur de 0,5 à 10 µm, de manière particulièrement préférée de 1 à 5 µm, de manière tout particulièrement préférée de 2 µm, et **en ce que** le système de couches multicouche est appliqué sur cette couche de base d'AlTiN par dépôt alterné de couches de CrTaN et d'AlTiN.

11. Procédé selon la revendication 10, **caractérisé en ce que**, à la place d'AlTiN, une couche de base d'AlTiXN est déposée, X = Ta, V, Si, Mo ou Hf, et **en ce que** AlTiXN est de préférence déposé à partir d'une cible composite.

12. Procédé selon l'une quelconque des revendications précédentes, **caractérisé en ce qu'**une couche de couverture en TiN ou en CrTaN est appliquée sur le système de couches multicouche par dépôt physique en phase vapeur (PVD), de préférence avec une épaisseur de 0,1 à 10 µm, de préférence de 0,5 à 5 µm et de manière particulièrement préférée de 1 µm.

13. Outil d'usinage par enlèvement de matière comprenant un substrat en métal dur,
**caractérisé en ce qu'**un système de couches multicouche est appliqué sur le substrat par dépôt physique en phase vapeur (PVD) par dépôt alterné de couches de CrTaN et d'AlTiN, AlTiN étant appliqué dans une composition atomique AlₓTi₁₋ₓN avec 0,2≤x≤0,9 et CrTaN étant appliqué dans une composition atomique Cr_{1-y}Ta_{y}N avec 0,01≤y≤0,65, mesurée par GDOES ou EDX, et les couches individuelles du système de couches multicouche étant appliquées dans des épaisseurs comprises entre 5 et 200 nm et 10 à 5000 couches étant déposées en alternance.

14. Outil d'usinage par enlèvement de matière selon la revendication 13, **caractérisé en ce qu'**une couche de base d'AlTiN est prévue entre le substrat et le système de couches multicouche CrTaN/AlTiN, de préférence dans une épaisseur de 0,5 à 10 µm, de manière particulièrement préférée de 1 à 5 µm, de manière tout particulièrement préférée de 2 µm.

15. Outil d'usinage par enlèvement de matière selon la revendication 13 ou 14, **caractérisé en ce qu'**au moins une couche de couverture en TiN ou en CrTaN est appliquée sur le système de couches multicouche CrTaN/AlTiN, de préférence avec une épaisseur de 0,1 à 10 µm, de préférence de 0,5 à 5 µm et de manière particulièrement préférée de 1 µm.
